## Europäisches Patentamt

## European Patent Office

## Office européen des brevets

(11) Numéro de publication : **0 033 696**
**B1**

(12) **FASCICULE DE BREVET EUROPÉEN**

(45) Date de publication du fascicule du brevet :
**18.01.84**

(21) Numéro de dépôt : **81400147.5**

(22) Date de dépôt : **30.01.81**

(51) Int. Cl.³ : **H 01 L 21/265**, H 01 L 21/324,
H 01 L 21/268, H 01 L 21/263

(54) **Procédé de dopage de semiconducteurs.**

(30) Priorité : **01.02.80 FR 8002238**

(43) Date de publication de la demande :
**12.08.81 Bulletin 81/32**

(45) Mention de la délivrance du brevet :
**18.01.84 Bulletin 84/03**

(84) Etats contractants désignés :
**CH DE GB LI**

(56) Documents cités :
**GB-A- 1 336 846**
**GB-A- 1 402 998**
**US-A- 3 562 022**
**IBM TECHNICAL DISCLOSURE BULLETIN, vol. 20,
no. 7, décembre 1977, pages 2590-2591 New York,
U.S.A. H.J. GEIPEL JR. et al.: "Ultrathin layer transistors"**
**JOURNAL OF THE ELECTROCHEMICAL SOCIETY,
vol. 126, no. 8, août 1979, page 361C Princeton, U.S.A.
I. GOLECKI et al.: "Transient annealing of GaAs by
electron and laser beams"**

(73) Titulaire : **COMMISSARIAT A L'ENERGIE ATOMIQUE
Etablissement de Caractère Scientifique Technique
et Industriel
B.P. 510
F-75752 Paris Cedex 15 (FR)**

(72) Inventeur : **Bruel, Michel
Lotissement Presvert No 9
F-38113 Veurey-Voroize (FR)**
Inventeur : **Floccari, Michel
39, rue Bizanet
F-38000 Grenoble (FR)**

(74) Mandataire : **Mongrédien, André et al
c/o BREVATOME 25, rue de Ponthieu
F-75008 Paris (FR)**

Procédé de dopage de semiconducteur

La présente invention concerne un procédé de dopage de semiconducteurs.

On sait que le dopage d'un semiconducteur consiste à faire pénétrer ou implanter des particules étrangères, ou impuretés dans un substrat constitué du semiconducteur à doper, et à rendre ces impuretés électriquement actives. L'adjonction d'impuretés dans un semiconducteur permet de modifier les propriétés physiques de celui-ci et, notamment, ses propriétés électriques.

On connaît plusieurs procédés de dopage des semiconducteurs comme, par exemple, l'implantation ionique, la diffusion, la croissance épitaxiale, la technique d'alliage, etc... Ces différents types de procédés de dopage présentent certains inconvénients et, en particulier, de ne pas être d'un emploi universel.

En effet, suivant les particules dopantes utilisées et/ou le matériau constituant le semiconducteur à doper, on utilise tel ou tel procédé. De plus, la mise en œuvre de ces différents procédés est plus ou moins complexe.

Le fascicule de brevet US-A 3 562 022 décrit un procédé de dopage de semiconducteurs conforme au préambule de la revendication 1, dans lequel, cependant le recuit est un recuit thermique. Ceci présente des inconvénients, qui seront exposés ci-après.

La présente invention a donc pour objet un procédé de dopage de semiconducteurs permettant de remédier à ces inconvénients et notamment, de présenter une mise en œuvre simple et universelle.

Ce procédé de dopage de semiconducteurs comprend, dans l'ordre, les étapes suivantes :

— une implantation par recul des particules dopantes dans le substrat, qui consiste à déposer sur la surface du substrat une couche de matériau, contenant des particules dopantes, et à bombarder ladite couche au moyen d'un faisceau de particules de bombardement, de façon à faire pénétrer les particules dopantes dans le substrat ;

— une élimination de la couche de matériau déposée sur la surface du substrat ;

— un recuit permettant de rendre électriquement actives les particules dopantes implantées, de façon à modifier les propriétés physiques du substrat ;

— ledit procédé étant caractérisé en ce que le recuit est un recuit transitoire, qui consiste à apporter à la surface, ou au niveau des premières couches implantées, pendant un temps très bref, une densité d'énergie telle que de très hautes températures soient atteintes, de façon à produire une liquéfaction locale des premières couches du substrat.

Selon une autre caractéristique de l'invention, les différentes étapes du procédé sont réalisées dans une même enceinte sous vide.

Selon un mode préféré de l'invention, le faisceau de particules de bombardement est constitué par un faisceau d'ions de gaz rare.

La présente invention présente bien les avantages cités précédemment.

En effet, on sait toujours réaliser le dépôt sur la surface de n'importe quel corps constituant le substrat, d'une couche mince de n'importe quel corps ou composé, constituant le matériau contenant les particules dopantes. De même, il est toujours facile de réaliser et d'utiliser un faisceau d'ions de gaz rare.

De plus, le fait d'utiliser un faisceau d'ions très intense, permet une implantation par recul très rapide, et le fait d'utiliser un recuit transitoire, qui est une étape rapide du procédé, permet d'obtenir à une très grande cadence le dopage de semiconducteurs de toutes sortes.

D'autres caractéristiques et avantages de l'invention ressortiront mieux à l'aide de la description qui va suivre, donnée à titre purement illustratif et non limitatif, en référence aux figures annexées dans lesquelles :

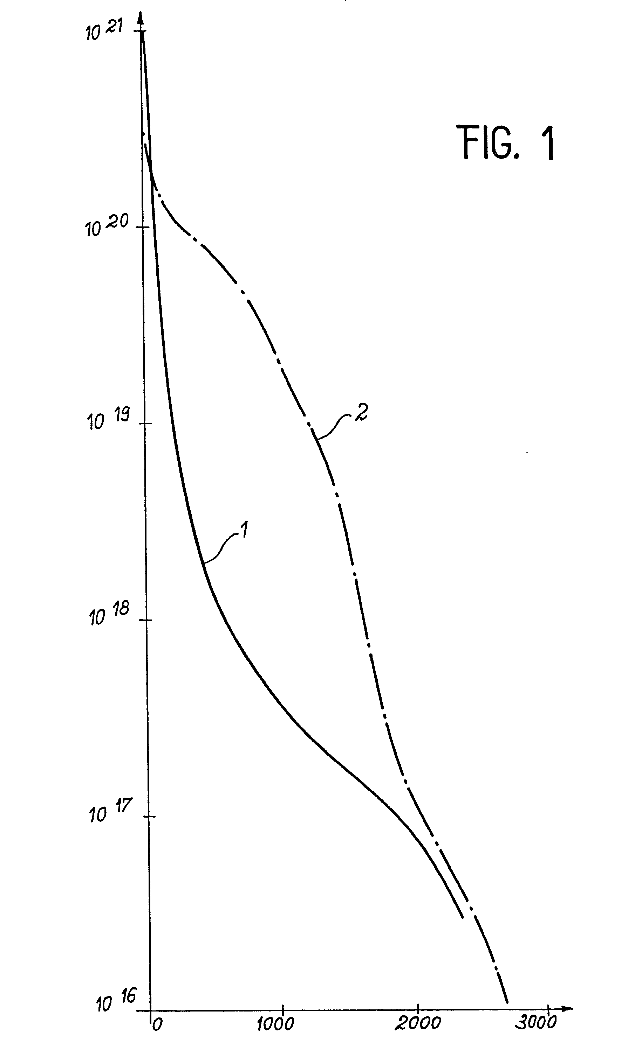

la figure 1 représente deux courbes montrant le profil d'une implantation par recul (nombre d'atomes implantés dans le substrat par centimètre cube, exprimé en puissance de dix, en fonction de la profondeur d'implantation dans le substrat, exprimée en Angströms), la courbe 1 représentant le profil de l'implantation avant un recuit transitoire, la courbe 2, le profil de l'implantation après un recuit transitoire ;

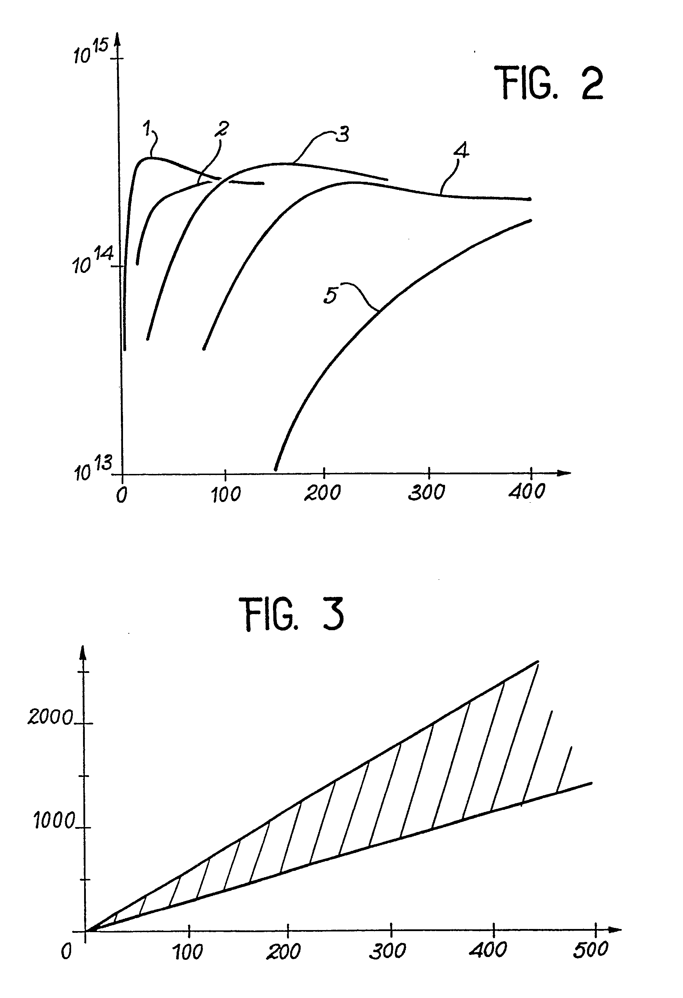

la figure 2 représente cinq courbes montrant l'efficacité du recul (nombre de particules pénétrant dans le substrat) en fonction de l'énergie des particules de bombardement (exprimée en kilo-électron-volt) pour différentes épaisseurs de la couche déposée sur le substrat ;

la figure 3 représente un domaine d'efficacité stationnaire de l'implantation par recul de particules d'Antimoine dans un substrat en Silicium à l'aide d'un faisceau de particules d'Argon (épaisseur de la couche d'Antimoine exprimée en Angströms en fonction de l'énergie des particules incidentes d'Argon exprimée en kilo-électron-volt).

Le procédé de dopage de semiconducteurs, conformément à l'invention se présente sous différentes étapes que l'on va décrire.

La première étape est une implantation par recul qui consiste à faire pénétrer les particules dopantes (atomes ou ions) dans un substrat constitué du semiconducteur à doper. Les particules dopantes sont contenues dans une couche de matériau déposée sur la surface du substrat, de préférence, par évaporation. L'énergie nécessaire à la pénétration des particules dans le substrat, comprise entre quelques électrons-volts et plusieurs kilos-électrons-volts provient d'un transfert d'énergie entre un faisceau de particules de bombardement et, en particulier non dopantes, qui vient bombarder la couche déposée sur le substrat, et les particules dopantes contenues dans ladite couche.

En utilisant un faisceau d'ions de gaz rare très intense, de préférence, de l'Argon, l'implantation par recul constitue une étape rapide du procédé.

La deuxième étape du procédé consiste à éliminer, après implantation, la couche de matériau déposée sur la surface du substrat. L'élimination de cette couche peut se faire : soit par sublimation sous vide, soit par attaque chimique, soit par pulvérisation ionique. La pulvérisation ionique peut être faite à l'aide d'un faisceau d'ions, qui peut être de même constitution que le faisceau d'ions utilisé pour l'implantation par recul. Ce faisceau d'ions est de préférence un faisceau d'ions d'Argon. Bien entendu, les énergies transportées par ces faisceaux peuvent être différentes. En effet, l'implantation par recul demande des énergies plus importantes que la pulvérisation ionique.

La troisième étape consiste à réaliser un recuit transitoire, permettant le positionnement des particules dopantes dans les sites interstitiels du réseau cristallin du substrat, et le réarrangement de ce réseau, perturbé lors de la pénétration des particules dopantes dans le substrat. Ce recuit transitoire qui consiste à apporter à la surface, ou au niveau des premières couches implantées, pendant un temps très bref, une densité d'énergie telle que de très hautes températures soient atteintes de façon à produire une liquéfaction locale des premières couches du substrat, peut être réalisé à l'aide d'un faisceau pulsé d'électrons ou à l'aide d'un tir laser.

Les différentes étapes du procédé, quel que soit leur mode de réalisation peuvent être réalisées dans une même enceinte et sous vide.

Du fait que les techniques utilisées pour déposer la couche de matériau dopant puis son élimination sont connues, il ne sera pas envisagé de description plus détaillée.

Ce procédé de dopage conforme à l'invention a été réalisé avec une couche de matériau, contenant des particules dopantes, en Antimoine, et un substrat en Silicium. L'implantation par recul a été effectuée au moyen d'un faisceau de particules d'Argon transportant une énergie de 100 keV. Le dépôt de la couche de matériau dopant a été effectué comme décrit ci-dessus ainsi que son élimination. En utilisant l'élimination par pulvérisation ionique à l'aide d'un faisceau de particules d'Argon, il suffit d'utiliser un faisceau transportant une énergie de 500 eV à 1 keV, c'est-à-dire environ 100 à 200 fois moins énergétique que pour l'implantation par recul. Pour le recuit transitoire par tir laser, il a été utilisé un laser à rubis transportant 0,3 Joule d'énergie sous forme d'impulsion durant 15 nanosecondes. Le recuit transitoire par pulse d'électrons a été réalisé à l'aide de machines type SPI 300 et SPI 5 000 commercialisées par la Société SPIRE (USA) permettant d'apporter une densité d'énergie de l'ordre de 1 J/cm².

Des études détaillées de ce procédé de dopage ont montré que, l'association d'une implantation par recul à un recuit transitoire, conduit à un dopage rapide et efficace de semiconducteurs.

En effet, en se référant à la figure 1, et en particulier à la courbe 1 représentant le profil d'une implantation par recul, avant le recuit transitoire, on constate que la concentration en surface des particules dopantes est très élevée, en général 100 fois plus élevée que la concentration obtenue par une méthode d'implantation classique. La courbe 2 représente ce que devient la courbe 1, c'est-à-dire l'implantation par recul, après un recuit transitoire. Les profils de l'implantation par recul ont été tracés sur l'un des isotopes de l'Antimoine implanté dans du Silicium. Le recuit transitoire a été effectué à l'aide d'un faisceau pulsé d'électrons.

Le fait d'utiliser un recuit transitoire permet de faire pénétrer les particules d'Antimoine dans le Silicium en profondeur. De plus, le fait d'utiliser un tel recuit ne fait pas ressortir les particules d'Antimoine que l'on a introduites par l'implantation par recul. En effet, par intégration du profil de concentration et par mesure directe grâce à l'analyse par activation neutronique, on a vérifié sur les profils tracés (courbes 1 et 2) que, à 15 % près, le nombre de particules d'Antimoine par centimètre cube introduites dans le substrat est le même que le nombre de particules dopantes présentes dans le substrat en Silicium, après un recuit transitoire. En revanche, si on utilise un recuit classique, c'est-à-dire le fait de porter le substrat implanté à haute température pendant un temps plus ou moins long, on constate que 80 à 90 % des particules implantées ressortent du substrat, ceci étant lié à la forte concentration des particules dopantes implantées présentes en surface. De plus, les qualités électriques d'un tel semiconducteur (implantation par recul, suivi d'un recuit classique) sont très inférieures à celles que l'on obtient pour le même recuit, avec une implantation classique. En revanche, les qualités électriques obtenues pour un semiconducteur dopé, conformément à l'invention (implantation par recul suivi d'un recuit transitoire) sont les mêmes que celles que l'on obtient avec un dopage classique (implantation ionique classique et recuit classique), en particulier les résistivités sont égales à la précision de la mesure près (environ 50 Ohms par carré pour $5 \cdot 10^{14}$ ions d'Antimoine, implantés par recul par cm²).

D'autres études ont montré que la présence d'un gaz rare dans le substrat, due à l'implantation par recul avec un faisceau d'ions de gaz rare, en particulier l'Argon, n'explique pas les anomalies obtenues lors de l'utilisation d'un recuit classique.

De plus, le procédé de dopage selon l'invention a l'avantage de présenter dans certaines conditions un domaine d'état stationnaire en ce qui concerne l'efficacité du recul, c'est-à-dire le nombre de particules dopantes pénétrant dans le substrat par particules de bombardement. En général, cette efficacité dépend de l'énergie apportée par les particules de bombardement et de l'épaisseur de la couche de matériau déposée sur le substrat, mais il existe des plages où cette efficacité est stationnaire, c'est-à-dire que le nombre de particules dopantes pénétrant dans le substrat ne dépend que du nombre de particules de bombardement incidentes. Le nombre de particules de bombardement étant contrôlable de façon simple et avec précision, rend l'utilisation du procédé facile à maîtriser. Il est à noter que l'efficacité du recul peut être supérieure à un et peut atteindre une valeur égale à trois.

Le domaine d'état stationnaire est illustré à l'aide des cinq courbes de la figure 2 et de la courbe de la figure 3.

La figure 2 représente l'efficacité du recul en fonction de l'énergie des particules de bombardement. Les particules dopantes sont constituées par de l'Antimoine, le substrat est en Silicium, les particules de bombardement sont constituées par des ions d'Argon. Le faisceau d'ions d'Argon utilisé pour les cinq courbes est le même et contient $3 \times 10^{14}$ ions/cm$^2$.

La courbe 1 correspond à une couche d'Antimoine déposée sur le substrat de 150 Å d'épaisseur, la courbe 2 à une couche de 300 Å, la courbe 3 à une couche de 620 Å, la courbe 4 à une couche de 1 200 Å et la courbe 5 à une couche de 2 500 Å. On constate à l'aide de ces cinq courbes que le nombre de particules implantées par recul pour une épaisseur donnée et à partir d'une énergie donnée, tend vers une valeur de $6 \times 10^{14}$/cm$^2$, ce qui correspond au double du nombre de particules d'Argon incidentes. Bien entendu, cette valeur est plus ou moins vite atteinte suivant l'épaisseur de la couche déposée et l'énergie nécessaire est plus ou moins importante. Ceci montre qu'il existe des plages (fonction de l'énergie des particules incidentes et de l'épaisseur) où cette efficacité est stationnaire.

Ce résultat est bien illustré par la figure 3. Le domaine où l'efficacité du recul est stationnaire, est représenté par la zone hachurée. Ce domaine correspond à une implantation de particules d'Antimoine dans du Silicium, à l'aide d'un faisceau d'ions d'Argon. Cette courbe permet de montrer que l'efficacité du recul varie peu lorsque l'épaisseur de la couche déposée sur le substrat et/ou l'énergie des particules incidentes varient de façon notoire. Dans ce domaine, l'efficacité du recul est de l'ordre de deux.

On notera que ce domaine d'efficacité stationnaire n'est pas particulier au procédé utilisant l'Argon et l'Antimoine pour doper le Silicium. L'existence de l'importance de ce domaine sont liées à la répartition entre le freinage électronique et le freinage nucléaire se produisant dans la couche déposée. Le fait que l'efficacité est stationnaire est favorisé par une prédominance du freinage nucléaire. Ce domaine d'efficacité stationnaire est différent lorsque l'on modifie l'un des trois paramètres : nature de la couche déposée, nature de la particule ou de l'ion, de bombardement, nature du substrat.

Ce procédé de dopage, simple à mettre en œuvre et rapide, peut être appliqué à la fabrication de cellules solaires à base de Silicium ou d'un autre semiconducteur.

**Revendications**

1. Procédé de dopage de semiconducteurs comprenant, dans l'ordre, les étapes suivantes :
— une implantation par recul de particules dopantes dans un substrat, qui consiste à déposer sur la surface du substrat une couche de matériau contenant des particules dopantes, et à bombarder ladite couche au moyen d'un faisceau de particules de bombardement, de façon à faire pénétrer les particules dopantes dans le substrat ;
— une élimination de la couche de matériau déposée sur la surface du substrat ; et,
— un recuit permettant de rendre électriquement actives les particules dopantes implantées, de façon à modifier les propriétés physiques du substrat, caractérisé en ce que le recuit est un recuit transitoire, qui consiste à apporter à la surface, ou au niveau des premières couches implantées, pendant un temps très bref, une densité d'énergie telle que de très hautes températures soient atteintes, de façon à produire une liquéfaction locale des premières couches du substrat.

2. Procédé de dopage selon la revendication 1, caractérisé en ce que la couche de matériau contenant les particules dopantes est réalisée par évaporation.

3. Procédé de dopage selon l'une quelconque des revendications 1 et 2, caractérisé en ce que le faisceau de particules de bombardements est constitué par un faisceau d'ions de gaz rare.

4. Procédé de dopage selon l'une quelconque des revendications 1 à 3, caractérisé en ce que la couche de matériau déposée sur le substrat est éliminée par sublimation.

5. Procédé de dopage selon l'une quelconque des revendications 1 à 3, caractérisé en ce que la couche de matériau déposée sur le substrat est éliminée au moyen d'une attaque chimique.

6. Procédé de dopage selon l'une quelconque des revendications 1 à 3, caractérisé en ce que la couche de matériau déposée sur le substrat est éliminée par pulvérisation ionique à l'aide d'un faisceau d'ions.

7. Procédé de dopage selon l'une quelconque des revendications 1 à 6, caractérisé en ce que le recuit transitoire est réalisé à l'aide d'un faisceau pulsé d'électrons.

8. Procédé de dopage selon l'une quelconque des revendications 1 à 6, caractérisé en ce que le recuit transitoire est réalisé à l'aide d'un tir laser.

9. Procédé de dopage selon l'une quelconque des revendications 1 à 4 et 6 à 8, caractérisé en ce que les différentes étapes du procédé sont réalisées dans une même enceinte sous vide.

10. Procédé de dopage selon les revendications 3 et 6, caractérisé en ce que le faisceau d'ions utilisé pour l'implantation par recul est de même constitution que celui qui est utilisé pour éliminer la couche de matériau déposée.

11. Procédé, selon l'une quelconque des revendications 1 à 10, de dopage du Silicium par de l'Antimoine à l'aide d'un bombardement d'ions Argon, caractérisé en ce que l'on réalise le bombardement de manière à se situer dans un domaine d'efficacité stationnaire délimité par deux droites représentatives de l'énergie des particules de bombardement en fonction de l'épaisseur de la couche de matériau dopant, ledit domaine étant celui dans lequel le nombre de particules dopantes pénétrant dans le substrat ne dépend que du nombre, contrôlable, de particules de bombardement incidentes.

## Claims

1. Process for doping semiconductors comprising, in order, the following steps :
— implantation by diffusion of dopant particles into a substrate, which comprises depositing on the surface of the substrate a layer of material containing dopant particles, and bombarding said layer by means of a beam of bombarding particles, whereby the dopant particles penetrate into the substrate ;
— elimination of the layer of material deposited on the surface of the substrate ; and
— annealing whereby the implanted dopant particles are rendered electrically active whereby to modify the physical properties of the substrate, characterized in that the annealing is a transitory annealing which comprises subjecting the surface, or the first implanted layers, for a very brief period to an energy density such that very high temperatures are reached, whereby to produce localized melting of the first layers of substrate.

2. Doping process according to claim 1, characterized in that the layer of material containing dopant particles is formed by evaporation.

3. Doping process according to either of claims 1 and 2, characterized in that the beam of bombarding particles comprises a beam of rare gas ions.

4. Doping process according to any one of claims 1 to 3, characterized in that the layer of material deposited on the substrate is eliminated by sublimation.

5. Doping process according to any one of claims 1 to 3, characterized in that the layer of material deposited on the substrate is eliminated by means of chemical attack.

6. Doping process according to any one of claims 1 to 3, characterized in that the layer of material deposited on the substrate is eliminated by ionic pulverization with the aid of an ion beam.

7. Doping process according to any one of claims 1 to 6, characterized in that the transitory annealing is achieved by means of a pulsed electron beam.

8. Doping process according to any one of claims 1 to 6, characterized in that the transitory annealing is achieved by means of a laser beam.

9. Doping process according to any one of claims 1 to 4 and 6 to 8, characterized in that the different steps of the process are carried out under vacuum in the same vessel.

10. Doping process according to claims 3 and 6, characterized in that the ion beam employed for implantation by diffusion has the same constitution as the one employed to eliminate the layer of deposited material.

11. Process, according to any one of claims 1 to 10, for doping silicon with antimony by means of bombardment with argon ions characterized in that bombardment is carried out in a region of constant efficiency delimited by two straight lines representative of the energy of bombarding particles as a function of the thickness of the layer of dopant material, said region being one in which the number of dopant particles penetrating into the substrate depends only on the controllable number of incident bombarding particles.

## Ansprüche

1. Verfahren zum Dotieren von Halbleitern, welches nacheinander die folgenden Schritte umfaßt :
— eine Stoßimplantation von Dotationspartikeln in ein Subtrat, welche darin besteht, daß man auf die Oberfläche des Substrats eine Schicht aus einem die Dotationspartikel enthaltenden Material deponiert und die Schicht mit einem Bündel von Beschußteilchen beschießt, so daß die Dotationspartikel dadurch in das Substrat eindringen,
— das Entfernen der auf der Oberfläche des Substrats deponierten Materialschicht und
— ein Erhitzen zum elektrischen aktivieren der implantierten Dotationspartikel durch Veränderung der phsikalischen Eigenschfaten des Substrats, dadurch gekennzeichnet, daß das Erhitzen eine kurzzeitige Erhitzung ist, welche darin besteht, daß man der Oberfläche oder dem Niveau der ersten implantierten Schichten während einer sehr kurzen Zeitspanne eine derartige Energiedichte zuführt, daß dadurch sehr hohe Temperaturen erzielt werden, so daß sich eine örtliche Verflüssigung der ersten Schichten des Substrats ergibt.

2. Dotierverfahren nach Anspruch 1, dadurch gekennzeichnet, daß die Schicht aus dem die Dotationspartikel enthaltenden Material durch Bedampfung hergestellt wird.

3. Dotierverfahren nach einem der Ansprüche 1 oder 2, dadurch gekennzeichnet, daß das Bündel aus Beschußpartikeln durch ein Bündel aus Ionen eines Edelgases gebildet wird.

4. Dotierverfahren nach einem der Ansprüche 1 bis 3, dadurch gekennzeichnet, daß die auf dem Substrat deponierte Materialschicht durch Sublimation entfernt wird.

5. Dotierverfahren nach einem der Ansprüche 1 bis 3, dadurch gekennzeichnet, daß die auf dem Substrat deponierte Materialschicht durch chemischen Angriff entfernt wird.

6. Dotierverfahren nach einem der Ansprüche 1 bis 3, dadurch gekennzeichnet, daß die auf dem Substrat deponierte Materialschicht durch ionische Zerstäubung mittels eines Ionen-

strahls entfernt wird.

7. Dotierverfahren nach einem der Ansprüche 1 bis 6, dadurch gekennzeichnet, daß die kurzzeitige Erhitzung mittels eines pulsierenden Elektronenstrahls herbeigeführt wird.

8. Dotierverfahren nach einem der Ansprüche 1 bis 6, dadurch gekennzeichnet, daß die kurzzeitige Erhitzung mittels eines Laserstrahls bewirkt wird.

9. Dotierverfahren nach einem der Ansprüche 1 bis 4 und 6 bis 8, dadurch gekennzeichnet, daß die verschiedenen Verfahrensschritte in ein und demselben geschlossenen Raum unter Vakuumbedingungen durchgeführt werden.

10. Dotierverfahren nach den Ansprüchen 3 und 6, dadurch gekennzeichnet, daß der für die Stoßimplantation verwendete Ionenstrahl die gleiche Zusammensetzung hat wie der zum Entfernen der deponierten Materialschicht Verwendete.

11. Verfahren nach einem der Ansprüche 1 bis 10 zum Dotieren von Silizium mit Antimon durch Beschuß mit Argonionen, dadurch gekennzeichnet, daß man den Beschuß in der Weise durchführt, daß er in einem in Abhängigkeit von der Dicke der Schicht aus dem Dotationsmaterial durch zwei für die Energie der Beschußteilchen representative Gerade begrenzten, stationären Wirksamkeitsbereich liegt, wobei der genannte Bereich derjenige ist, in welchem die Anzahl der in die Unterlage eindringenden Dotationspartikel allein von der steuerbaren Anzahl der auftreffenden Beschußteilchen abhängig ist.

FIG. 1

FIG. 2

FIG. 3